# EUROPÄISCHE PATENTSCHRIFT

(11) **EP 3 185 527 B1**
(45) Veröffentlichungstag und Bekanntmachung des Hinweises auf die Patenterteilung: **13.02.2019**
(21) Anmeldenummer: 15202242.2
(22) Anmeldetag: 22.12.2015
(51) Int. Cl.: H04M 11/06, H05K 5/00

(54) **ZUGANGSVORRICHTUNG FÜR INTERNET- UND TELEFONANSCHLÜSSE**
ACCESS DEVICE FOR INTERNET AND TELEPHONE CONNECTIONS
DISPOSITIF D'ACCES POUR RACCORDEMENTS INTERNET ET TELEPHONE

(43) Veröffentlichungstag der Anmeldung: 28.06.2017
(73) Patentinhaber: Deutsche Telekom AG, 53113 Bonn (DE)
(72) Erfinder: WINTER, Alexander, 57612 Birnbach (DE); THIES, Emil, 47166 Duisburg (DE)
(74) Vertreter: Brandt & Nern Patentanwälte

(56) Entgegenhaltungen:
- EP-A1- 1 788 853
- EP-A1- 2 095 573
- US-A1- 2009 013 257
- US-A1- 2014 168 904

## Beschreibung

Die Erfindung betrifft eine Zugangsvorrichtung für Internet- und Telefonanschlüsse mit einem Gehäusebaustein, welcher aus einem mit einer Gehäusebasisfront versehenen Gehäusebasiselement, in dem mindestens eine mit elektronischen Bauteilen für die Bereitstellung des Internet- und Telefonzuganges zum Netz versehene Platine angeordnet ist und einer an der Frontseite des Gehäusebasiselementes angeordneten Gehäuseabdeckung besteht, wobei die Gehäuseabdeckung mindestens eine Aussparung für ein Anzeigeelement zur Kontrolle der von der Zugangsvorrichtung bereitgestellten Anschlussfunktionen aufweist.

Zugangsvorrichtungen der eingangs geschilderten gattungsgemäßen Art sind im Rahmen der Nutzung von Internet und Telefonanschlüssen allgemein üblich. Je nach Nutzung dieser Anschlüsse sind dabei Zugangsvorrichtungen mit unterschiedlicher Konfiguration notwendig. Elementar für einen Internetanschluss ist beispielsweise ein Modem. Bei der Nutzung durch mehr als einen Rechner wird darüber hinaus noch ein Router mit einem entsprechenden Ethernetport benötigt.

Da heutzutage oftmals eine drahtlose Kommunikation zwischen Rechner und Router gewünscht ist, ist in vielen Zugangsvorrichtungen darüber hinaus ein WLAN-Modul bzw. ein WLAN-Access-Point integriert. Die verschiedenen Konfigurationen der Zugangsvorrichtungen werden dabei möglichst als ein geschlossenes Endgerät konzipiert, um für den Kunden den Aufbau und Betrieb des Internet- bzw. Telefonanschlusses möglichst einfach zu gestalten. Dabei ist es für die Anbieter natürlich geboten, die Kosten eines derartigen Gerätes möglichst gering zu halten. Zu diesem Zweck werden die Komponenten, die zu einer entsprechenden Zugangsvorrichtung gehören, zur Steigerung einer rationellen Fertigung in aller Regel auf einer Platine zusammengefasst, wodurch eine Änderung der für die Konfiguration und Nutzung eines Internet- bzw. Telefonanschlusses notwendigen Komponenten in aller Regel ausscheidet.

Falls somit beispielsweise das in einer herkömmlichen Zugangsvorrichtung integrierte Modem aufgrund einer durch das Modem nicht unterstützten Technologie (DSL oder VDSL oder Glasfasertechnologie) nicht verwendet werden kann, so ist üblicherweise das komplette Endgerät auszutauschen oder der Router mit einem zusätzlichen externen Modem zu verwenden, das gegebenenfalls an einem WAN-Port des Endgerätes eingesteckt werden kann.

Für spezielle Anwendungsfälle ist aus dem Stand der Technik auch die Möglichkeit bekannt, eine für das Festnetz vorgesehene Zugangsvorrichtung mit einer Erweiterung zu versehen, die die Nutzung eines Mobilfunknetzes ermöglicht. Zu diesem Zweck wird in einen vorhandenen USB-Port an der Zugangsvorrichtung ein für die Nutzung des Mobilfunknetzes notwendiger UMTS- oder LTE-Stick eingesteckt.

Die aus dem Stand der Technik bekannten Zugangsvorrichtungen werden aufgrund der Tatsache, dass sie überwiegend von Telekommunikationskonzernen bereitgestellt werden, in der Regel auch für klassische Kommunikationsdienste wie Telefon und Telefax benutzt. Aus diesem Grunde existieren auch Zugangsvorrichtungen mit integrierter Telefonanlage, wobei die Ausstattung beispielsweise mit DECT-Basisstationen, analogen und/oder ISDN-Anschlussmöglichkeiten je nach Modell variiert. Für die Unterstützung klassischer analoger Telekommunikation benötigt das Endgerät somit einen entsprechenden Eingang.

Da aufgrund einer Weiterentwicklung der Kommunikation im Internet zunehmend eine Umstellung des klassischen Telefonnetzes auf die sogenannte "Voice over IP-Technologie" erfolgt, besteht für viele Nutzer die Problematik, einen ISDN-Adapter zusammen mit dem ihm von seinem Telefonanbieter zur Verfügung gestellten Zugangsvorrichtung verwenden zu müssen, da die neuerdings von den Telekommunikationskonzernen bereitgestellten Endgeräte aus Kostengründen auf entsprechende ISDN-Anschlüsse verzichten.

Im Stand der Technik existieren darüber hinaus neben den Zugangsvorrichtungen mit den oben beschriebenen Einzelfunktionen auch Modelle, die die Möglichkeit bieten, weitere Endgeräte in das lokale Haus- oder Betriebsnetz einzubinden. Dies können beispielsweise Drucker oder externe Festplatten sein, für welche die Zugangsvorrichtungen dann die Funktion eines Medienservers/Webservers oder Fileservers übernehmen.
Nachteilig an den aus dem Stand der Technik bekannten Zugangsvorrichtungen ist es, dass durch die hohe Anzahl verschiedener Kundenanforderungen die Anzahl unterschiedlicher Geräte am Markt groß ist, wobei durch die Massenproduktion einzelner Varianten trotzdem nicht alle Kundenwünsche optimal abgedeckt werden können. Darüber hinaus empfindet es der Kunde nicht als vorteilhaft, wenn er bei einer Veränderung der Technologie seines Internet- und Telefonanschlusses ein unter Umständen noch relativ neues und funktionsfähiges Gerät durch ein der neuen Technologie angepasstes neues Gerät ersetzen muss, wobei je nach Service die Kosten für eine derartige Umstellung vom Kunden oder vom Telekommunikationskonzern getragen werden müssen.

Aus der EP 2 095 573 B1 ist eine Lösung für eine auch den Zugang zum Internet ermöglichende Netzwerkeinrichtung bekannt geworden, welche auf einem modularen Ansatz basiert. Bei der in der Druckschrift beschriebenen Netzwerkeinrichtung ist ein Grundmodul (Uplink-Modul) vorgesehen, welches ein externes Netzwerk, wie insbesondere ein Weitverkehrsnetz, terminiert. Das Uplink-Modul stellt seinerseits ausgangsseitig einen Ethernet-Port zur Verfügung, über welchen mindestens ein weiteres Funktionsmodul mit diesem Grundmodul verbindbar ist. Im Falle einer Verbindung mehrerer Funktionsmodule mit dem Grundmodul sind diese in Reihe zueinander und zum Grundmodul angeordnet, wobei zur Verteilung der Datenströme zwischen ihnen und dem Grundmodul ein Switch-Modul anzuordnen ist. Die in Reihe angeordneten Funktionsmodule, einschließlich des Switch-Moduls werden durch das Grundmodul mit Spannung versorgt.

Als nachteilig ist es bei dieser bekannten Lösung anzusehen, dass im Falle des Ausfalls eines der Funktionsmodule - jedenfalls im Falle des Ausfalls eines nicht am Ende dieser Reihenschaltung angeordneten Moduls - auch die anderen Funktionsmodule bis zur Reparatur beziehungsweise bis zum Austausch des defekten Moduls nicht genutzt werden können. Ferner ist die Netzwerkeinrichtung insoweit nicht flexibel, als sie nicht wahlweise unter Verwendung eines von mehreren Nutzer-Accounts verschiedener, unterschiedliche Zugangstechniken einsetzender Provider nutzbar ist, sondern jeweils nur im Rahmen der durch das jeweils zum Einsatz gelangende Grundmodul unterstützen Zugangstechnik. Anderenfalls müsste das Switch-Modul in seiner Funktionalität gewissermaßen vom zweiten Layer des ISO 7 Layer Modells auf den dritten Layer dieses Schichtenmodells gehoben werden, um als Router fungieren zu können.

Ausgehend von den geschilderten Nachteilen bestehender gattungsgemäßer Zugangsvorrichtungen für Internet und Telefonanschlüsse besteht die Aufgabe der Erfindung darin, eine Möglichkeit zu schaffen, nahezu alle vorhandenen Technologien im Internet- und Telefonbereich für den Kunden so bereitstellen zu können, dass diese durch ihn flexibel und vorzugsweise auch wahlweise, das heißt wechselweise nutzbar sind ohne dass dies durch Einsatz völlig neuer Geräte und den damit verbundenen Kostenaufwand verbunden ist. Damit verbunden ist natürlich eine Reduzierung nicht mehr verwendeter Hardware, die als sogenannter "Elektroschrott" entsorgt bzw. recycelt werden muss.

Die gestellte Aufgabe wird für eine Zugangsvorrichtung mit den gattungsbildenden Merkmalen des Anspruches 1 durch die im kennzeichnenden Teil des Anspruches beschriebene technische Lehre gelöst.

Erfindungswesentlich dabei ist es, dass das Gehäusebasiselement der Zugangsvorrichtung an seiner der Gehäuseabdeckung abgewandten Rückseite mindestens einen Anschlussbereich I für USB-Sticks mit Funktionalitätserweiterungsbausteinen und mindestens einen Anschlussbereich II für Adapterbausteine zur Verbindung mit externen Endgeräten aufweist, wobei die Anschlussbereiche Verbindungselemente zur Platine aufweisen und dass an der Gehäusebasisfront an der Vorderseite des Gehäusebasiselementes eine Ausnehmung zur Aufnahme einer Anzeige-/Bedieneinheit ausgespart ist.

Alle wesentlichen Komponenten der erfindungsgemäßen Zugangsvorrichtung sind austauschbar konzipiert und werden entweder dem Anschlussbereich I oder dem Anschlussbereich II zugeordnet, wobei die zur im Inneren der Zugangsvorrichtung vorhandenen Platine dienenden Verbindungselemente auf der USB-Anschlusstechnologie basieren, da es sich hierbei um eine erprobte und standardisierte Anwendung handelt.

Erfindungsgemäß ist die Zugangsvorrichtung zudem so beschaffen, dass die Anschlussbereiche I und II an den gegenüberliegenden Seiten eines zum Gehäusebasiselement gehörenden, an der der vorderen Gehäuseabdeckung abgewandten Rückseite mittig vorstehenden Anschlusssteges angeordnet sind. Der mittig angeordnete Anschlusssteg ermöglicht eine optische und technische Trennung der Anschlussbereiche I und II und dient gleichzeitig dazu, die für die Funktion der erfindungsgemäßen Zugangsvorrichtung notwendigen USB-Sticks und Anschlussadapter mittels des abdeckenden Anschlusssteges mit der im Innern der Zugangsvorrichtung vorhandenen zentralen Platine verbinden. Diese Verbindung kann mittels einer Leiterbahnzusatzplatine erfolgen, auf der die Verbindungselemente zum Anschluss der Anschlussadapter und USB-Sticks festgelegt sind, was eine Vormontage der entsprechenden Bauteile ermöglicht und den Montageaufwand reduziert.

Wie bereits erwähnt geschildert, basieren die Verbindungselemente zwischen USB-Sticks, Anschlussadaptern und der inneren Hauptplatine der Zugangsvorrichtung auf der USB-Anschlusstechnologie sind, sind also als USB-Anschlüsse ausgebildet. Je nach Anwendung können dabei unterschiedliche USB-Anschlussvarianten wie beispielsweise Mini-USB oder Typ A, B oder C eingesetzt werden.

Es handelt sich hierbei um eine erprobte und standardisierte Technologie, so dass die anzuschließenden USB-Sticks und Adapterbausteine, die für ihre Funktion notwendigen Treiberprogramme und sonstigen Informationen zur Integration in die Zugangsvorrichtung über die genormten Anschlüsse direkt übermitteln können.

Die Ausgestaltung der Verbindungselemente als USB-Buchsen eröffnet darüber hinaus die Möglichkeit, auf der Hauptplatine einen USB-Bus zur Verbindung der USB-Sticks und der Anschlussadapter mit einer auf der Platine zusätzlich vorhandenen Kontroll- und Steuereinheit auszustatten.

Durch die am Gehäusebasiselement vorhandenen Anschlussbereiche I und II ist erstmals die Möglichkeit gegeben, eine Vorfestlegung auf bestimmte Anschlusstechnologien zu vermeiden. Sollte der Nutzer einer erfindungsgemäßen Zugangsvorrichtung sein Nutzungs-verhalten ändern bzw. erweiterte Möglichkeiten des Zugangs wünschen, so erfolgt aufgrund des nunmehr modularen Aufbaus der erfindungsgemäßen Zugangsvorrichtung nur noch der Austausch bzw. die Erweiterung einzelner Komponenten der Zugangsvorrichtung, um die Kundenwünsche zu realisieren.

Für die mit der Bereitstellung derartiger Zugangsvorrichtungen betrauten Telekommunikationskonzerne besteht aufgrund der Erfindung die Möglichkeit, jedes einzelne gewünschte Feature, welches eine Zugangsvorrichtung für Internet- und Telefonanschlüsse erbringen muss, kostengünstiger als bisher zu gestalten, da der Aufwand für die Entwicklung, die Wartung, den Support und den Vertrieb getrennter Modelllinien entfällt. Für den Kunden bedeutet dies, dass er sich in Zukunft sicher entscheiden kann und nicht zum gegenwärtigen Zeitpunkt beispielsweise einen Router wegen einer bestimmten Anschlusstechnologie (z.B. LTE Hybrid) erwirbt, sich zu einem zukünftigen Zeitpunkt jedoch aufgrund geänderter Rahmenbedingungen den erworbenen Router gegen ein anderes Zugangsgerät tauschen muss, weil dieses eine andere Technologie (z.B. Smarthome / integrierte Qivicon Basestation) unterstützt. Bislang kann es dabei sogar vorkommen, dass ein Kunde durch den Austausch der Zugangsvorrichtung eine bislang für ihn nutzbare Technologie wieder verliert, falls das neu erworbene Zugangsgerät diese "alte Technologie" nicht unterstützt.

Die Telekommunikationskonzerne profitieren durch den erfindungsgemäßen modularen Aufbau der Zugangsvorrichtung von der Vereinfachung in den Betriebswegen, wobei zu berücksichtigen ist, dass das Angebot unterschiedlicher Dienste immer an die Verfügbarkeit einer entsprechenden Hardwarefunktionen gekoppelt ist und somit umso mehr Einnahmen über diese Dienste erwirtschaftet werden können, je einfacher diese Bereitstellung der Hardwarekomponenten für den Kunden realisiert werden kann.

In diesem Zusammenhang ist sicherlich als zusätzlicher Vorteil der Erfindung zu berücksichtigen, dass der Einbau einer großen Zahl von unterschiedlichen Zugangsmöglichkeiten prophylaktisch in eine einzige Zugangsvorrichtung nicht mehr notwendig ist. Die dadurch eingesparten hohen Investitions- und Betriebskosten sind dabei in Zusammenhang zu sehen mit der Tatsache, dass derartige hochpreisige Zugangsvorrichtungen aufgrund ihrer Komplexität häufig aktualisiert werden mussten, was oftmals mit einem Austausch der Geräte verbunden war.

Es hat sich darüber hinaus als zweckmäßig erwiesen, den Anschlussbereich I für die USB-Sticks an der oberen Seite des dann horizontal angeordneten Anschlusssteges anzuordnen und mit einem Abdeckelement I so zu überdecken, dass die dort an die Verbindungselemente ankoppelbaren USB-Sticks vollständig unter dem Abdeckelement I aufgenommen sind.

Die zur Anwendung gelangenden USB-Sticks sind Einzelbauteile und bis auf den für den Anschluss an die Zugangsvorrichtung notwendigen USB-Stecker ohne Außenanschlüsse und mit einem geschlossenen Gehäuse versehen. Aus diesem Grunde ist ein Zugriff auf die USB-Sticks nach dem Einstecken in die Verbindungselemente der erfindungsgemäßen Zugangsvorrichtung nicht weiter notwendig, so dass aus ästhetischen Gründen und zur Verhinderung von Staubablagerungen das Abdeckelement I alle Steckplätze möglicher USB-Sticks überdecken kann.

Vorteilhaft kann es ferner sein, den Anschlussbereich II für die Adapterbausteine an der unteren Seite des Anschlusssteges angeordnet mit einem Abdeckelement II zu überdecken, wobei das Abdeckelement II mindestens in einem Teilbereich eines jeden Adapterbausteines eine Aussparung zum Anschluss eines Signalkabels an den Adapterbaustein aufweist. Da die Adapterbausteine verschiedene Anschlussmöglichkeiten an die Zugangsvorrichtung bereitstellen sollen (TAE-Stecker, ISDN-Stecker, Ethernet-Stecker, USB-Stecker für externe Geräte) sollten die entsprechenden Signalleitungen zu einer Seite oder bei einer Wandmontage der Zugangsvorrichtung vorzugsweise nach unten vom Gerät wegführen.

Auch hier ist eine Abdeckung aus ästhetischen Gründen vorteilhaft, die jedoch mit den oben erwähnten Aussparungen versehen sein muss. Da die Adapterbausteine bei einer Wandmontage der Zugangsvorrichtung und einer horizontalen Anordnung des Anschlusssteges von unten in die Verbindungselemente eingesteckt werden, kann es darüber hinaus vorteilhaft sein, wenn an der Abdeckung II eine Haltevorrichtung zur Fixierung der Adapterbausteine innerhalb des Anschlussbereiches II vorhanden ist, so dass ein Herausfallen oder ein versehentliches Abziehen infolge der Montage von Signalleitungen ausgeschlossen wird.

Eine weitere vorteilhafte Ausbildung des Gegenstandes der Erfindung sieht vor, die Ausnehmung zur Aufnahme der Anzeige-/Bedieneinheit mit zwei an gegenüberliegenden Seiten angeordneten Profilnuten zu versehen, in die seitlich an der Anzeige-/Bedieneinheit befindliche vorstehende korrespondierende Schienenelemente einschiebbar sind. Die Verbindung zwischen Gehäuseabdeckung und Anzeige-/Bedieneinheit erfolgt durch die geschilderte funktionelle Ausgestaltung zuverlässig und ohne großen Montageaufwand. Auf diese Weise ist ein Austausch zwischen unterschiedlichen Varianten der Anzeige-/Bedieneinheit möglich, beispielsweise kann diese bei einer Zugangsvorrichtung im Falle ihrer Funktion als Modem oder Router ohne technische Funktion sein, da Anzeige- und Bedienelemente nicht notwendig sind. Die Anzeige- und Bedieneinheit dient in diesem Falle lediglich zum Verschließen der Ausnehmung, um ein einheitlich ästhetisch vorteilhaftes Gesamtbild zu gewährleisten.

Natürlich kann die Anzeige-/Bedieneinheit in einer ersten Ausbaustufe mit einer unterschiedlichen Anzahl von LEDs versehen werden, mit denen der Status des Gerätes und die momentan in Betrieb befindlichen Funktionen angezeigt werden. Neben diesen LEDs lassen sich entsprechende Beschriftungen anbringen, damit ein Nutzer die LED-Anzeige einer entsprechenden Funktion zuordnen kann. Eine LED mit nebenstehender W-LAN-Beschriftung würde somit beispielsweise im beleuchteten Zustand signalisieren, dass die WLAN-Funktion der Zugangsvorrichtung in Betrieb ist, wohingegen eine ausgeschaltete LED-Anzeige eine inaktive WLAN-Funktion anzeigt.

Sollte die Notwendigkeit bestehen, im Rahmen der Gesamtfunktion verschiedenen LEDs unterschiedliche Anzeigefunktionen zuzuordnen, so besteht entsprechend einer weiteren Ausgestaltungsvariante die Möglichkeit, durch Aufkleber auf der Anzeige-/Bedieneinheit die momentane Funktionsanzeige der LEDs zu verdeutlichen. Selbstverständlich kann die Funktion der LEDs auch durch Einschubschilder angezeigt werden, die in neben den LEDs befindliche Aufnahmen eingesetzt werden.

Darüber hinaus besteht die Möglichkeit, eine oder mehrere LEDs in eine Taste zu integrieren, so dass der angezeigte Status über das Drücken der Taste beeinflusst werden kann. Dabei können durch die Dauer des Drückens auch verschiedene Aktionen ausgelöst werden. Beispielsweise kann die für die Wlan-Funktion zuständige Taste bei kurzem Drücken die Wlan-Funktion aktivieren bzw. deaktivieren und bei langem Drücken die Zugangsvorrichtung mit einem Wlan-Endgerät per WPS koppeln.

Die komfortabelste Variante der Anzeige-/Bedieneinheit sieht einen LCD-Touchscreen vor, welcher frei programmierbar ist. Mit einer derartigen Ausgestaltung kann die Zugangsvorrichtung verschiedene Statusinformationen anzeigen und der Benutzer kann über Eingaben auf dem Touchscreen bestimmte Funktionen ansteuern oder verändern. Auf diese Weise ist bei einer Ausstattung der erfindungsgemäßen Zugangsvorrichtung mit neuen USB-Sticks oder Adapterbausteinen eine funktionale Erweiterung gewährleistet werden, da der Einbau der geschilderten Bausteine dem Nutzer auf dem Touchscreen unmittelbar angezeigt werden kann, ohne dass von einer statischen Beschriftung oder einer limitierten Anzahl von Tasten die Anzeige bestimmter Funktionalitäten behindert wird.

Die schon erwähnte Steuer- und Kontrolleinheit ist dabei ähnlich eines Mini-PC's ausgestaltet. Wesentliche Funktionen, die nur durch Software bereitgestellt werden können, werden durch die Kontroll- und Steuereinheit bereitgestellt und über definierte Module der Zugangsvorrichtung den einzelnen USB-Sticks bzw. Anschluss-adaptern zur Verfügung gestellt. Die Kontroll- und Steuereinheit kann dabei ein WAN-Traffic-Management bereitstellen, darüber hinaus besteht selbstverständlich die Möglichkeit, durch unterschiedliche Module wie WAN-Port, V-DSL-Access-Port, Mobilfunksticks oder dergleichen eine Internetverbindung zu ermöglichen und diese durch die Kontroll- und Steuereinheit managen zu lassen.

Einzelne Dienste wie z.B. VolP oder Datenstreams können dezidiert zu bestimmten WAN-Komponenten geroutet werden. Im Hybridbetrieb kann der Datenverkehr aufgeteilt und gleichmäßig oder entsprechend eines Verteilungsschlüssels auf die WAN-Komponenten verteilt werden. Damit dies effektiv geschehen kann (möglichst durch einen tiefen Layer im ISO/OSI-Schichtenmodell) sollte der Verkehr beim Internetserviceprovider wieder entsprechend zusammengeführt werden können.

Natürlich sind die normalen Funktionen einer Zugangsvorrichtung wie zum Aufbau einer Datenverbindung, der Bereitstellung einer Firewall sowie die Funktion eines Remote-Managements in der Steuer- und Kontrolleinheit als Basisfunktionen integriert und können durch Software-Updates erweitert oder aktualisiert werden.

Die Steuer- und Kontrolleinheit kann darüber hinaus entsprechende Module, wie einen Ethernet-LAN-Port, WLAN-Sticks und Bluetooth-Sticks zu einem lokalen Netzwerk verbinden. Dies betrifft selbstverständlich alle bekannten Konfigurationen z.B. Firewalling auf Paket- oder Anwendungsebene, Proxying, Viren-/Malewarefiltering, VPN, Unified-Thread-Management, zeitgesteuerte Beschränkungen, Webfiltering, Routing und die Erbringung von Netzdiensten, z.B. DHCP, DNS, NTP u.s.w.

Schlussendlich sollte die Kontroll- und Steuereinheit auch ein Telefonmanagement bereitstellen und entsprechende Adaptermodule wie TAE-, ISDN-, RJ45- und DECT-Bausteine einbinden können und die lokalen Telefonendgeräte mit dem Zugangsgerät koppeln. Dabei werden die Endgeräte entweder über entsprechende Module wie Mobilfunksticks, ISDN-Adapter, einem Adapter für analoge Telefonanschlüsse per RJ45 oder dergleichen an die Zugangsvorrichtung gekoppelt. Alternativ dazu ist es natürlich denkbar, mittels eines internen VoIP-Servers, der seinerseits über die oben erwähnten Datenverbindungen als VoIP-Client seine Informationen von einem VolP-Server bezieht, zu schalten.

Das Telefonmanagement stellt somit ein Routing zwischen den Modulen her und ermöglicht auch die Konfiguration von Telefondiensten, wie z.B. die Anzeige ausgehender Rufnummern bzw. alternativ eine Rufnummernunterdrückung bereit.

Darüber hinaus können natürlich auch durch entsprechende Programmierung Auswertungen wie der Datenverkehr verbundener Geräte oder auch eine Anrufliste bereitgestellt werden. Die geschilderten Funktionen werden über die interne Konfigurationsoberfläche und/oder einer APP-API dem Nutzer zur Verfügung gestellt.

Die letztgenannte Möglichkeit kann genutzt werden, um durch eigene Anwendungen (Apps), den Router zu konfigurieren und auszuwerten. Daneben können einzelne Module der Zugangsvorrichtung auch außerhalb des USB-Protokolls zugänglich gemacht werden. Auf diesem Wege können z.B. WLAN-Clients wie Module behandelt werden. Dies kann beispielsweise die Möglichkeit eröffnen, dass ein per WLAN verbundenes Smartphone mit einer App auf das Modul für die Telefonfunktionen der Zugangsvorrichtung zugreift und so wie ein Telefonendgerät an diesem Telefonmodul agieren kann.

Hinsichtlich der Handhabbarkeit der Abdeckelemente I und II sowie der vorderen Gehäuseabdeckung hat es sich darüber hinaus als zweckmäßig erwiesen, diese durch eine mechanische oder magnetische Koppelvorrichtung an dem Gehäusebasiselement festzulegen. Insbesondere eine magnetische Koppelvorrichtung ist hierbei vorteilhaft, da sie zum einen einfach realisierbar ist und zum anderen die magnetischen Haltekräfte zwar ausreichend zur Fixierung der Abdeckelemente sind, gleichzeitig aber keine hohen Lösungskräfte erfordern. Eine Ausgestaltung kann hier die Anbringung von Magneten am Gehäusebasiselement in definierten Positionen vorsehen, wohingegen an den Abdeckelementen I und II sowie der Gehäuseabdeckung korrespondierende Metalllaschen vorgesehen sind, die auf die von den Magneten bereitgestellten Anziehungskräfte reagieren und auf diese Weise in vorbestimmter Position fixiert sind.

Nachfolgend wird ein Ausführungsbeispiel des Gegenstandes der Erfindung anhand der beigefügten Zeichnungen näher erläutert. Es zeigt:
- Figur 1: eine Frontansicht der erfindungsgemäßen Zugangsvorrichtung für Internet- und Telefonanschlüsse ohne Gehäuseabdeckung
- Figur 2: eine Unteransicht der Zugangsvorrichtung entsprechend dem Pfeil A aus Figur 1 ohne Abdeckung,
- Figur 3: eine Oberansicht der Zugangsvorrichtung entsprechend dem Pfeil B aus Figur 1 ohne Abdeckung,
- Figur 4: eine Seitenansicht der Zugangsvorrichtung entsprechend dem Pfeil C aus Figur 1 ohne Abdeckungen,
- Figur 5: eine Rückansicht der erfindungsgemäßen Zugangsvorrichtung mit Abdeckungen,
- Figur 6: eine Seitenansicht der Zugangsvorrichtung entsprechend Pfeil D aus Figur 5 mit Abdeckungen,
- Figur 7: ein Detail D entsprechend der Kreisdarstellung aus Figur 6,
- Figur 8: die Vorderansicht einer erfindungsgemäßen Zugangsvorrichtung mit einer ersten Variante einer Anzeige-/Bedieneinheit und der Gehäuseabdeckung,
- Figur 9: die Vorderansicht einer erfindungsgemäßen Zugangsvorrichtung mit einer zweiten Variante einer Anzeige-/Bedieneinheit und der Gehäuseabdeckung,
- Figur 10: die Vorderansicht einer Zugangsvorrichtung mit einer dritten Variante einer Anzeige-/Bedieneinheit und der Gehäuseabdeckung,
- Figur 11: die Seitenansicht der erfindungsgemäßen Vorrichtung gemäß Figur 4 mit Abdeckungen
- Figur 12: die Unteransicht der erfindungsgemäßen Vorrichtung gemäß Figur 2 mit Abdeckungen
- Figur 13: die Oberansicht erfindungsgemäßen Vorrichtung gemäß Figur 3 mit Abdeckungen und
- Figur 14: die Seitenansicht der erfindungsgemäßen Vorrichtung gemäß Figur 6 ohne Abdeckungen

Die erfindungsgemäße Zugangsvorrichtung für Internet- und Telefonanschlüsse weist einen Gehäusebaustein 1 auf, der sich aus verschiedenen Komponenten zusammensetzt.

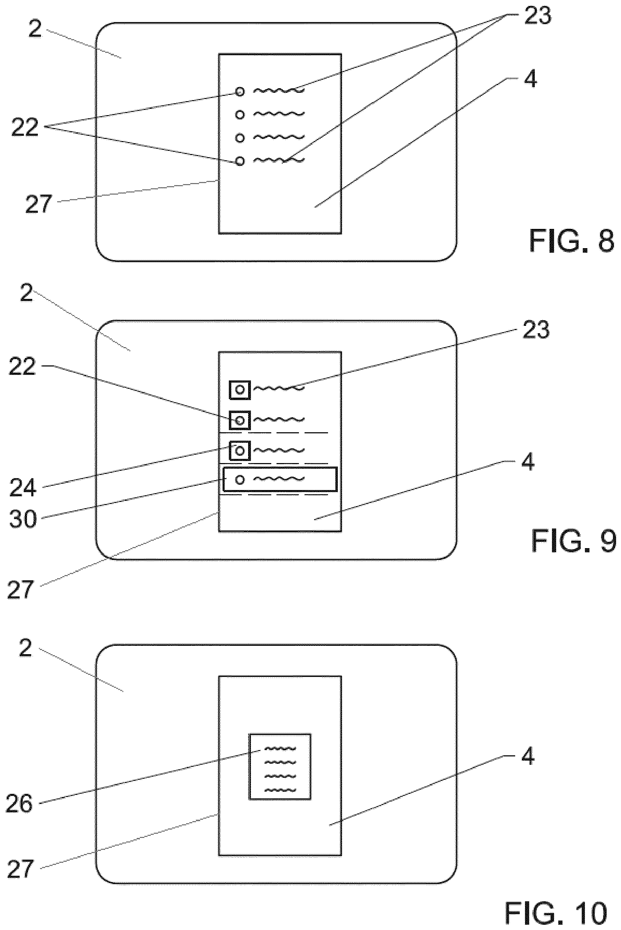

Grundelement ist dabei ein Gehäusebasiselement 1, welches im wesentlichen eine rechteckige Form aufweist und an seiner Vorderseite mit einer Gehäuseabdeckung 2 überdeckt ist. An der zur Außenseite hin gewandten Gehäusebasisfront 29 des Gehäusebasiselementes 1 befindet sich eine Ausnehmung 3, in welche eine Anzeige-/Bedieneinheit 4 einsetzbar ist. Diese bleibt durch eine Ausnehmung 27 (siehe Fig. 8 bis 10) in der Gehäuseabdeckung 2 teilweise sichtbar.

Zur Verbindung der Anzeige-/Bedieneinheit 4 mit der Gehäusebasisfront 29 ist am unteren geschlossenen Ende der Ausnehmung 3 ein USB-Anschluss 15 angeordnet, in den ein korrespondierender Stecker an der Anzeige-/Bedieneinheit 4 beim Einschieben in die Ausnehmung 3 automatisch eingeschoben wird, so dass eine elektrische Verbindung zwischen dem Gehäusebaustein 1 und der Anzeige-/Bedieneinheit 4 hergestellt ist.

Die Ausnehmung 3 ist im dargestellten Ausführungsbeispiel rechteckig ausgeführt und nach oben hin geöffnet, so dass das Einschieben der Anzeige-/Bedieneinheit erleichtert wird.

Die Halterung der Anzeige-/Bedieneinheit 4 kann dabei so erfolgen, dass an den Seitenwänden 5 und 6 in den Zeichnungen nicht näher dargestellte Profilnuten eingebracht sind, in die korrespondierende an der Anzeige-/Bedieneinheit 4 befindliche vorstehende Schienenelemente einschiebbar sind, so dass sich eine feste Fixierung ergibt.

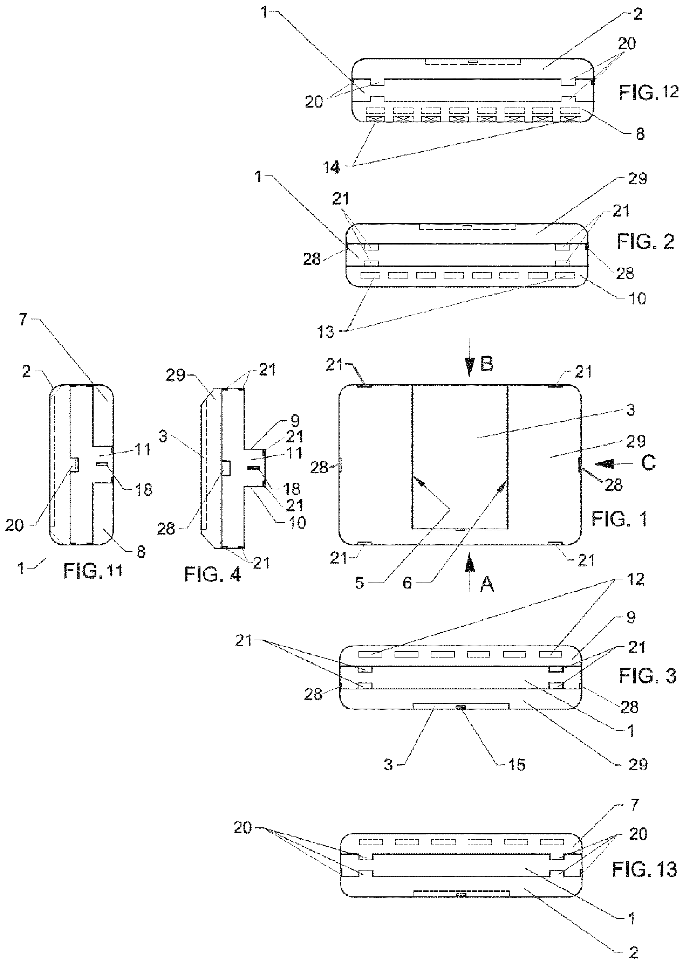

Weitere Elemente des Gehäusebausteines sind an der Rückseite je ein Abdeckelement I mit der Bezugsziffer 7 und ein Abdeckelement II mit der Bezugsziffer 8. Die Abdeckelemente I und II überdecken jeweils einen Anschlussbereich I mit der Bezugsziffer 9 und einen Anschlussbereich II mit der Bezugsziffer 10. Zwischen den Anschlussbereichen I und II befindet sich ein Anschlusssteg 11, der Bestandteil des Gehäusebasiselementes 1 ist. Der Verbindungssteg ist im dargestellten Ausführungsbeispiel horizontal angeordnet. An der nach oben weisenden Seitenwandung des Anschlusssteges 11 befinden sich, wie dies aus Figur 3 deutlich wird, eine Anzahl von Verbindungselementen 12 in Form von USB-Steckkontakten, im vorliegenden Fall insgesamt sechs. In diese Verbindungselemente 12 lassen sich jeweils sogenannte USB-Sticks einstecken, die die erfindungsgemäße Zugangsvorrichtung mit Zusatzfunktionen versehen, sofern ein Nutzer diese Zusatzfunktion wünscht. Die USB-Sticks weisen dabei keine externen Anschlussmöglichkeiten auf, so dass das obere Abdeckelement 7 den Anschlussbereich I nach dem Aufsetzen vollständig kapselt (siehe Figur 12).

Die zum Einsatz kommenden USB-Sticks können dabei beispielsweise folgende Funktionalitäten aufweisen:
Speichersticks: Sie dienen dazu, der Zugangsvorrichtung die Fähigkeit zum Speichern von Daten zu geben. Der Speicher kann als FTP-Server bzw. Medienserver bereitgestellt werden.

WLAN-Stick: Diese aus anderen Anwendungen wie beispielsweise bei Laptops bekannten Sticks beinhalten eine WLAN-Funktionalität der Zugangsvorrichtung. Dies hat zum einen den Vorteil, dass bei Bedarf WLAN-Technologien mit unterschiedlicher Bandbreite und unterschiedlichen Frequenzen kostengünstig eine vorhandene WLAN-Funktionalität verbessern können. Hierzu wird der bisherige WLAN-Stick durch einen anderen mit verbesserter Funktionalität ersetzt.

Darüber hinaus ist mit dem Einsetzen mehrere WLAN-Sticks auch das Betreiben mehrerer WLAN-Netze möglich, so dass neben einem Hausnetzwerk beispielsweise ein Gastnetzwerk oder ein Netzwerk für Drittanbieter als sogenannter Hotspot auch bekannt als WLan-To go beispielsweise von der Deutschen Telekom verwendet werden können.

Mobilfunksticks: Wie ebenfalls aus dem Bereich von Laptops bekannt, dienen diese Sticks der Verbindung mit einem Mobilfunknetz als alternativer (wie z.B. bei DSL via Funk) oder ergänzender (wie z.B. Hybrid) WAN-Zugang. Auch hier ist eine Verbesserung auf schnellere Technologien durch einfachen Austausch des entsprechenden Mobilfunksticks möglich. Neben der reinen Datenverbindung können derartige Sticks auch weitere Mobilfunkfunktionen an der Zugangsvorrichtung bereitstellen. So kann beispielsweise eine Telefonfunktion über das Mobilfunknetz angeboten werden, die dann vom Telefonmanagement der erfindungsgemäßen Zugangsvorrichtung genutzt wird.

DECT-Sticks: Derartige Sticks kapseln die DECT-Basisstation. In der jüngeren Vergangenheit sind bei dieser Technologie verschiedene Updates der Komfort-funktionen durchgeführt worden, wobei die Funktionalität der DECT-Sticks vom Telefonmanagement der Zugangsvorrichtung abgedeckt wird. Bluetooth-Sticks: Derartige Sticks dienen zur Verbindung von Headsets bzw. zur Synchronisation von Smartphones.

Smarthome-Module: Als Stickwort dienen hierbei z.B. Qivicon Basestation oder die Funktionen der HomeKit Bridge für Geräte der Firma Apple.

Wie eingangs bereits geschildert, können durch den Einbau unterschiedlicher USB-Sticks nahezu alle heutzutage denkbaren Funktionalitäten einer Zugangsvorrichtung realisiert werden, wobei eine Umrüstung auf andere zukünftige Funktionalitäten nur den Austausch entsprechender USB-Sticks notwendig macht, so dass auf die Lieferung einer gänzlich neuen Vorrichtung durch den Telekommunikationsanbieter verzichtet werden kann.

Der gegenüberliegende, im vorliegenden Ausführungsbeispiel nach unten weisende Seitenbereich des Anschlusssteges 11, welcher in der Figur 4 sichtbar ist, weist eine Reihe von Verbindungselementen 13 auf, die in der Zeichnung beispielhaft ebenfalls als USB-Buchsen dargestellt sind.

An diese Verbindungselemente 13 können sogenannte Adapterbausteine angebunden werden, wobei diese Adapterbausteine mit externen Anschlussmöglichkeiten für Signalleitungen oder dergleichen ausgestattet sind. Aus diesem Grunde muss das Abdeckelement 8 mit Aussparungen 14 versehen sein, so dass die nach außen weisende Seite der Adapterbausteine auch bei geschlossenem Abdeckelement 8 zugänglich bleiben.

Als Anschlussmöglichkeiten bzw. als Adapterbausteine sind in diesem Zusammenhang beispielsweise Bausteine mit verschiedenen Steckkontakten vorgesehen. Beispielhaft können an die Verbindungselemente 13 Adapterbausteine mit einem TAE-Anschluss für ein analoges Telefon, solche mit einem ISDN-Anschluss für einen S0-Buszugang, solche mit einem RJ45-Anschluss, ebenfalls zum Anschließen eines analogen Telefons vorgesehen sein. Ferner lassen sich Adapterbausteine mit einem Ethernet-Anschluss vorsehen, wobei je nach Preisklasse verschiedene Bandbreiten (Base 10/100/1000) vorgesehen werden können.

Natürlich ist es darüber hinaus denkbar, Adapterbausteine mit einem oder mehreren USB-Anschlüssen vorzusehen, um zusätzliche externe Endgeräte wie beispielsweise Drucker oder dergleichen an die erfindungsgemäße Zugangsvorrichtung koppeln zu können.

Ebenso ist es denkbar, Anschlussadapter mit einem Antennenanschluss für externe Antennen vorzusehen, wobei die empfangenen Signale dann über einen USB-Bus von anderen Erweiterungsbausteinen beispielsweise für Mobilfunk, WLAN oder dergleichen zur Verarbeitung bereitgestellt werden können.

Schließlich sind Anschlussadapter mit einem VDSL-Zugang oder einem WAN-Port denkbar, so dass die Zugangsvorrichtung als Modem für eine Internetverbindung zur Verfügung steht bzw. an eine bestehende Internetverbindung in Form eines externen Modems oder eines lokalen Netzwerkes anschließbar ist.

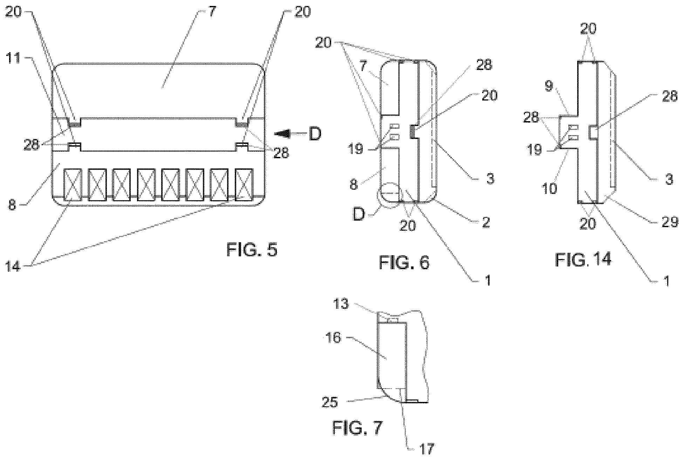

Um die Adapterbausteine im Anschlussbereich II in den Verbindungselementen 13 zu fixieren, sieht eine vorteilhafte Ausgestaltung des Erfindungsgegenstandes vor, dass die Adapterbausteine durch eine spezielle Gestaltung des unteren Abdeckelementes 8 gegen ein Herausfallen oder Herausziehen bei geschlossenem Abdeckelement 8 gesichert sind. Diese Sicherheitsfunktion wird dadurch realisiert, dass die Rundung 25 im unteren Bereich des Abdeckelementes 8 die nach unten weisende Wandung 17 eines jeden Anschlussadapters 16 untergreift. Dieses Prinzip ist in der Figur 7 entsprechend dem Detail D aus Figur 6 gut erkennbar.

In der Figur 4 ist erkennbar, dass am Gehäusebasiselement 1 neben den bereits erwähnten Verbindungselementen 12 und 13 ein zusätzlicher USB-Anschluss 18 vorgesehen ist. Es kann sich hierbei um einen Mini-USB-Anschluss oder einen Anschluss des Typs A, B oder C handeln. Die Hauptfunktionen dieses USB-Anschlusses 18 ist die Anbindung an eine Stromversorgung. Diese Art von Stromversorgung ist von Handys und Tablets hinlänglich bekannt. Derartige preiswert verfügbare Netzteile lassen sich somit bei einem Defekt leicht austauschen.

Der USB-Anschluss 18 kann darüber hinaus auch dafür vorgesehen werden, Daten an die erfindungsgemäße Zugangsvorrichtung zu übermitteln, in dem auf die Stromversorgung Daten aufmoduliert werden. Dies geschieht dadurch, dass der zur Stromversorgung vorgesehene Steckeradapter auch ein dLAN-Modul (auch als Power-Lan, Power-Line-Communication bzw. PCL bezeichnet) aufweist. Ein zusätzlicher dLAN-Adapter, welcher an einen der Verbindungselemente 13 angeschlossen werden müsste, kann so eingespart werden.

Auf der gegenüberliegenden Seite des Gehäusebasiselementes 1 befinden sich - wie dies aus der Figur 6 deutlich wird - zwei zusätzliche USB-Anschlüsse, über die zusätzliche externe Endgeräte wie Drucker oder Festplatten an die Zugangsvorrichtung angekoppelt werden können. Um die Abdeckelemente 7 und 8 sowie die Gehäuseabdeckung 2 mit dem Gehäusebasiselement 1 zu koppeln und gleichzeitig ein leichtes Abnehmen der Elemente zu gewährleisten, sind sowohl an der Gehäuseabdeckung 2 als auch an den Abdeckelementen 7 und 8 vorstehende Nasen 20 angeordnet, die als metallische Haltelaschen gestaltet sein können, oder mit einem metallischen Überzug versehen sind. In entsprechenden Ausnehmungen 21 und 28 am Gehäusebasiselement 1 werden zum Zwecke der Koppelung kleine nicht näher dargestellte Magnete eingesetzt, die beim Aufsetzen der Abdeckelemente 7, 8 sowie der Gehäuseabdeckung 2 in ihrem Zusammenwirken mit den Nasen 20 ausreichende Haltekräfte bereitstellen. Die Ausnehmungen 21 sind so dimensioniert, dass die jeweils korrespondierenden Nasen 20 in diese bündig eingreifen und diese Ausnehmungen21 somit vollständig verschließen, während die Ausnehmungen 28 seitlich am Gehäusebasiselement 1 etwas länger dimensioniert sind, sodass sich nach dem Aufsetzen der Abdeckungen vor der Nase 20 eine Lücke ergibt, die als Angriffspunkt eines Hilfsmittels zum Lösen der Haltekräfte genutzt werden kann.

Um die unterschiedlichen Betriebszustände der erfindungsgemäßen Zugangsvorrichtung für den Benutzer darzustellen, besitzt, wie oben bereits erwähnt, die Zugangsvorrichtung an ihrer Gehäusebasisfront 29 eine Ausnehmung 3, in die eine Anzeige-/Bedieneinheit 4 einsetzbar ist.

Diese Anzeige-/Bedieneinheit 4 kann je nach Ausstattung der Zugangsvorrichtung unterschiedlich ausgebildet sein. Als einfachste Variante ist eine sogenannte Blindvariante denkbar, in der ein Bauteil ohne technische Funktion zum Füllen der Ausnehmung 3 an der Gehäusebasisfront 29 eingesetzt wird, damit auch die Ausnehmung 27 in der Gehäuseabdeckung 2 optisch abgeschlossen ist.

Alternativ dazu kann die Anzeige-/Bedieneinheit 4 auf ihrer Außenseite eine Anzahl von LEDs aufweisen, die die verschiedenen Betriebszustände des Gerätes anzeigen. Zur Verdeutlichung der Anzeigefunktion einzelner LEDs sind neben diesen entsprechende Beschriftungen aufgebracht, wie dies beispielhaft schematisch in der Figur 8 dargestellt ist. Jeder LED 22 ist dabei eine eindeutige Beschriftung 23 zugeordnet. Diese Beschriftung kann auf dem Modul fest aufgedruckt sein, wobei es denkbar ist, den LEDs 22 unterschiedliche Funktionen zuzuordnen. In diesem Fall muss die zugehörige Beschriftung entweder allgemein gehalten sein (Ein/Aus) oder es müssen austauschbare Beschriftungen in Form von Aufklebern oder auf andere Weise an der Anzeige-/Bedieneinheit 4 zu befestigende Schilder vorgesehen werden.

Um bei der Anzeige-/Bedieneinheit 4 entsprechende Befehle der Zugangsvorrichtung zu übermitteln, kann es darüber hinaus zweckmäßig sein, die Anzeige-/Bedieneinheit 4 entsprechend der Figur 9 mit Tasten 24 zu versehen, die wiederum mit LEDs 22 ausgestattet sein können. Neben der Taste wird wiederum eine Beschriftung 23 vorgesehen. Alternativ kann die Dimension der Tasten vergrößert werden, sodass nicht nur die LED 22, sondern auch die Beschriftung 23 auf der Taste vorhanden ist, wie dies schematisch in der Fig. 9 durch die Taste 30 verdeutlicht ist. Eine Betätigung der Taste 24 löst dann in der Zugangsvorrichtung eine Funktion aus. Dies kann beispielsweise die Ein- oder Ausschaltung der WLAN-Funktion an der Zugangsvorrichtung sein.

Natürlich ist es wie in anderen Anwendungsfällen auch denkbar, durch ein zeitlich längeres Drücken einer entsprechenden Taste 24 unterschiedliche Befehle an die Zugangsvorrichtung zu übermitteln. Hier ist beispielsweise die Koppelung zweier WLAN-Geräte per WPS durch eine längere Betätigung einer Taste 24 denkbar.

Die komfortabelste Variante der Anzeige-/Bedieneinheit 4 sieht entsprechend einer vorteilhaften Weiterbildung der Erfindung vor, statt der vorher geschilderten LEDs und Tasten einen LCD-Bildschirm 25 vorzusehen. Mit Hilfe einer derartigen technischen Realisierung kann die Zugangsvorrichtung zum einen unterschiedliche Statusinformationen anzeigen, darüber hinaus kann ein Benutzer über entsprechende Berührung des Touchscreens Funktionalitäten der Zugangsvorrichtung ändern. Auf diese Weise ist beispielsweise beim Austausch von Elementen im Anschlussbereich I oder II die Möglichkeit gegeben, die entsprechenden Bauelemente zu konfigurieren und dem Nutzer eine dynamische Statusanzeige bereitzustellen, ohne dass eine vorhandene Beschriftung oder eine begrenzte Anzahl von Tasten zu Einschränkungen der Bedienung führt.

### Bezugszeichenliste:

- 1.: Gehäusebasiselement
- 2.: Gehäuseabdeckung
- 3.: Ausnehmung
- 4.: Anzeige-/Bedieneinheit
- 5.: Seitenwand
- 6.: Seitenwand
- 7.: Abdeckelement I
- 8.: Abdeckelement II
- 9.: Anschlussbereich I
- 10.: Anschlussbereich II
- 11.: Anschlusssteg
- 12.: Verbindungselement
- 13.: Verbindungselement
- 14.: Aussparung
- 15.: USB-Anschluss
- 16.: Anschlussadapter
- 17.: Wandung
- 18.: USB-Anschluss
- 19.: USB-Anschluss
- 20.: Nase
- 21.: Ausnehmung
- 22.: LED
- 23.: Beschriftung
- 24.: Taste
- 25.: Rundung
- 26.: LCD Touchscreen
- 27.: Aussparung
- 28.: Ausnehmung
- 29.: Gehäusebasisfront
- 30.: Taste

## Patentansprüche

1. Zugangsvorrichtung für Internet- und Telefonanschlüsse mit einem Gehäusebaustein, welcher aus einem mit einer Gehäusebasisfront (29) versehenen Gehäusebasiselement (1), in dem mindestens eine mit elektronischen Bauteilen für die Bereitstellung des Internet- und Telefonzuganges zum Netz versehene Platine angeordnet ist, und einer an der Frontseite des Gehäusebasiselementes (1) angeordneten Gehäuseabdeckung (2) besteht, wobei die Gehäuseabdeckung (2) mindestens eine Aussparung (27) für ein Anzeigeelement zur Kontrolle der von der Zugangsvorrichtung bereitgestellten Anschlussfunktionen aufweist, **dadurch gekennzeichnet,**
**dass** an der Gehäusebasisfront (29) an der Vorderseite des Gehäusebasiselementes (1) eine Ausnehmung (3) zur Aufnahme einer Anzeige-/Bedieneinheit (4) ausgespart ist und
**dass** das Gehäusebasiselement (1) an seiner der Gehäuseabdeckung (2) abgewandten Rückseite mindestens einen Anschlussbereich I (9) für USB-Sticks mit Funktionalitätserweiterungsbausteinen und mindestens einen Anschlussbereich II (10) für Adapterbausteine zur Verbindung mit externen Endgeräten aufweist, wobei die Anschlussbereiche (9, 10) I und II an den gegenüberliegenden Seiten eines zum Gehäusebasiselement (1) gehörenden, an der der Gehäusebasisfront (29) abgewandten Rückseite mittig vorstehenden Anschlusssteges (11) angeordnet sind und
**dass** die Platine mit einer Kontroll- und Steuereinheit ausgestattet und auf der Platine ein USB-Bus zur Verbindung der USB-Sticks, der Anschlussadapter (16) und der Anzeige-/Bedieneinheit (4) angeordnet ist, wobei die Anzeige-/Bedieneinheit 4 mit der Gehäusebasisfront 29 über einen USB-Anschluss (15) und mit der Platine innerhalb des Gehäusebasiselementes (1) verbunden ist und wobei die Anschlussbereiche (9, 10) I und II über Verbindungselemente (12, 13) in Form von USB-Anschlüssen des Anschlusssteges (11) und über den USB-Bus mit der Kontroll- und Steuereinheit auf der Platine verbunden sind.

2. Zugangsvorrichtung nach Anspruch 1, **dadurch gekennzeichnet, dass** der Anschlussbereich I (9) für die USB-Sticks an der oberen Seite des Anschlusssteges (11) angeordnet, von einem Abdeckelement I (7) so überdeckt ist, dass die dort an die Verbindungselemente (12) ankoppelbaren USB-Sticks vollständig unter dem Abdeckelement I (7) aufgenommen sind.

3. Zugangsvorrichtung nach einem der Ansprüche 1 oder 2, **dadurch gekennzeichnet, dass** der Anschlussbereich II (10) für die Adapterbausteine an der unteren Seite des Anschlusssteges (11) angeordnet von einem Abdeckelement II (8) überdeckt ist, wobei das Abdeckelement II (8) mindestens in einem Teilbereich eines jeden Adapterbausteines eine Aussparung (14) zum Anschluss eines Signalkabels an den Adapterbaustein aufweist.

4. Zugangsvorrichtung nach Anspruch 3, **dadurch gekennzeichnet, dass** das Abdeckelement II (8) eine Haltevorrichtung zur Fixierung der Adapterbausteine innerhalb des Anschlussbereiches II (10) an den Verbindungselementen (13) aufweist.

5. Zugangsvorrichtung nach einem der Ansprüche 1 bis 4, **dadurch gekennzeichnet, dass** die Ausnehmung (3) zur Aufnahme der Anzeige-/Bedieneinheit (4) zwei an gegenüberliegenden Seiten angeordnete Profilnuten aufweist, in die seitlich an der Anzeige-/ Bedieneinheit (4) befindliche vorstehende Schienenelemente einschiebbar sind.

6. Zugangsvorrichtung nach einem der Ansprüche 1 bis 5, **dadurch gekennzeichnet, dass** die Anzeige-/Bedieneinheit (4) als LCD-Touchscreen (26) ausgebildet ist.

7. Zugangsvorrichtung nach einem der Ansprüche 1 bis 6, **dadurch gekennzeichnet, dass** die Abdeckelemente I und II (7, 8) und die vordere Gehäuseabdeckung (2) durch eine mechanische Verriegelungsvorrichtung an dem Gehäusebasiselement (1) festlegbar sind.

8. Zugangsvorrichtung nach einem der Ansprüche 1 bis 6, **dadurch gekennzeichnet, dass** die Abdeckelemente I und II (7, 8) und die vordere Gehäuseabdeckung (2) durch eine magnetische Koppelvorrichtung an dem Gehäusebasiselement (1) festlegbar sind.

9. Zugangsvorrichtung nach einem der Ansprüche 1 bis 8, **dadurch gekennzeichnet, dass** die Stromversorgung der Zugangsvorrichtung über einen USB-Anschluss (18) erfolgt, der zusätzlich zur Stromabnahme von einem Netzteil an dieses Netzteil Daten senden und Daten von diesem Netzteil empfangen kann, die das Netzteil mit einem integrierten dLan-Modem über das Stromnetz mit anderen dLan-Modems austauscht.

## Claims

1. Access device for Internet and telephone connections, comprising a housing module which comprises a housing base element (1), which is provided with a housing base (29) and in which at least one printed circuit board which is provided with electronic components for providing the Internet and telephone access to the network is arranged, and a housing cover (2) which is arranged on the front side of the housing base element (1), wherein the housing cover (2) has at least one cutout (27) for a display element for monitoring the connection functions which are provided by the access device,
**characterized**
**in that** a recess (3) for receiving a display/operator control unit (4) is cut out from the housing base front (29) on the front side of the housing base element (1), and
**in that** the housing base element (1) has, on its rear side which is averted from the housing cover (2), at least one connection region I (9) for USB sticks with functionality expanding modules and at least one connection region II (10) for adapter modules for connection to external terminal devices, wherein the connection regions (9, 10) I and II are arranged on the opposite sides of a connection web (11) which forms part of the housing base element (1) and projects centrally from the rear side which is averted from the housing base front (29), and
**in that** the printed circuit board is equipped with a monitoring and control unit, and a USB bus for connecting the USB sticks, the connection adapter (16) and the display/operator control unit (4) is arranged on the printed circuit board, wherein the display/operator control unit (4) is connected to the housing base front (29) by means of a USB connection (15) and to the printed circuit board within the housing base element (1), and wherein the connection regions (9, 10) I and II are connected to the monitoring and control unit on the printed circuit board by means of connecting elements (12, 13) in the form of USB connections of the connection web (11) and by means of the USB bus.

2. Access device according to Claim 1, **characterized in that** the connection region I (9) for the USB sticks, in a manner arranged on the upper side of the connection web (11), is covered by a covering element I (7) such that the USB sticks which can be coupled to the connecting elements (12) are accommodated completely beneath the covering element I (7) there.

3. Access device according to either of Claims 1 and 2, **characterized in that** the connection region II (10) for the adapter modules, in a manner arranged on the lower side of the connection web (11), is covered by a covering element II (8), wherein the covering element II (8) has, at least in a subregion of each adapter module, a cutout (14) for connecting a signal cable to the adapter module.

4. Access device according to Claim 3, **characterized in that** the covering element II (8) has a holding device for fixing the adapter modules to the connecting elements (13) within the connection region II (10).

5. Access device according to one of Claims 1 to 4, **characterized in that** the recess (3) for receiving the display/operator control unit (4) has two profile grooves which are arranged on opposite sides and into which protruding rail elements which are located on the sides of the display/operator control unit (4) can be inserted.

6. Access device according to one of Claims 1 to 5, **characterized in that** the display/operator control unit (4) is designed as an LCD touchscreen (26).

7. Access device according to one of Claims 1 to 6, **characterized in that** the covering elements I and II (7, 8) and the front housing cover (2) can be secured to the housing base element (1) by a mechanical locking device.

8. Access device according to one of Claims 1 to 6, **characterized in that** the covering elements I and II (7, 8) and the front housing cover (2) can be secured to the housing base element (1) by a magnetic coupling device.

9. Access device according to one of Claims 1 to 8, **characterized in that** power is supplied to the access device by means of a USB connection (18) which, in addition to drawing power from a power supply unit, can send data to this power supply unit and receive data from this power supply unit, the power supply unit with an integrated dLan modem exchanging said data with other dLan modems by means of the power supply system.

## Revendications

1. Dispositif d'accès pour des connexions Internet et téléphonique, comprenant un module de boîtier, lequel se compose d'un élément de base de boîtier (1) pourvu d'une face avant de base de boîtier (29), dans lequel est disposée au moins une platine pourvue de composants électroniques pour la mise à disposition de l'accès Internet et téléphonique vers le réseau, et d'un couvercle de boîtier (2) disposé au niveau du côté avant de l'élément de base de boîtier (1), le couvercle de boîtier (2) possédant au moins un dégagement (27) pour un élément indicateur servant au contrôle des fonctions de connexion mises à disposition par le dispositif d'accès,
**caractérisé en ce**
**qu'**une cavité (3) servant à accueillir une unité d'indication/opération (4) est dégagée au niveau de la face avant de base de boîtier (29) sur le côté avant de l'élément de base de boîtier (1) et
**que** l'élément de base de boîtier (1) possède sur son côté arrière à l'opposé du couvercle de boîtier (2) au moins une zone de connexion I (9) pour une clé USB dotée de modules d'extension de fonctionnalité et au moins une zone de connexion II (10) pour des modules adaptateurs servant à la liaison avec des terminaux externes, les zones de connexion I et II (9, 10) étant disposées au niveau des côtés opposés d'un élément jointif de connexion (11) appartenant à l'élément de base de boîtier (1) et faisant saillie au centre au niveau du côté arrière à l'opposé de la face avant de base de boîtier (29) et
**que** la platine est équipée d'une unité de contrôle et de commande et sur la platine est disposé un bus USB servant à la liaison de la clé USB, de l'adaptateur de connexion (16) et de l'unité d'indication/opération (4), l'unité d'indication/opération (4) étant reliée à la face avant de base de boîtier (29) par le biais d'une connexion USB (15) et à la platine à l'intérieur de l'élément de base de boîtier (1) et les zones de connexion I et II (9, 10) étant reliées par le biais d'éléments de liaison (12, 13) sous la forme de connexions USB de l'élément jointif de connexion (11) et par le biais du bus USB à l'unité de contrôle et de commande sur la platine.

2. Dispositif d'accès selon la revendication 1, **caractérisé en ce que** la zone de connexion I (9) pour la clé USB disposée au niveau du côté supérieur de l'élément jointif de connexion (11) est recouverte par un élément de protection I (7) de telle sorte que la clé USB qui peut être accouplée aux éléments de liaison (12) à cet endroit est entièrement accueillie sous l'élément de protection I (7).

3. Dispositif d'accès selon l'une des revendications 1 ou 2, **caractérisé en ce que** la zone de connexion II (10) pour les modules adaptateurs disposée au niveau du côté inférieur de l'élément jointif de connexion (11) est recouverte par un élément de protection II (8), l'élément de protection II (8) possédant dans au moins une zone partielle d'un module adaptateur respectif un dégagement (14) destiné à la connexion d'un câble de signal au module adaptateur.

4. Dispositif d'accès selon la revendication 3, **caractérisé en ce que** l'élément de protection II (8) possède un dispositif de maintien servant la fixation du module adaptateur à l'intérieur de la zone de connexion II (10) aux éléments de liaison (13).

5. Dispositif d'accès selon l'une des revendications 1 à 4, **caractérisé en ce que** la cavité (3) possède des rainures profilées disposées au niveau de côtés opposés et servant à accueillir l'unité d'indication/opération (4), dans lesquelles peuvent être insérés des éléments de glissière en saillie qui se trouvent latéralement sur l'unité d'indication/opération (4).

6. Dispositif d'accès selon l'une des revendications 1 à 5, **caractérisé en ce que** l'unité d'indication/opération (4) est réalisée sous la forme d'un écran tactile LCD (26).

7. Dispositif d'accès selon l'une des revendications 1 à 6, **caractérisé en ce que** les éléments de protection I et II (7, 8) et le couvercle de boîtier (2) avant peuvent être bloqués au niveau de l'élément de base de boîtier (1) par un dispositif de verrouillage mécanique.

8. Dispositif d'accès selon l'une des revendications 1 à 6, **caractérisé en ce que** les éléments de protection I et II (7, 8) et le couvercle de boîtier (2) avant peuvent être bloqués au niveau de l'élément de base de boîtier (1) par un dispositif de couplage magnétique.

9. Dispositif d'accès selon l'une des revendications 1 à 8, **caractérisé en ce que** l'alimentation électrique du dispositif d'accès est réalisée par le biais d'une connexion USB (18) qui, en plus du prélèvement de courant depuis un bloc d'alimentation secteur, peut envoyer à ce bloc d'alimentation secteur des données et recevoir de la part de ce bloc d'alimentation secteur des données que le bloc d'alimentation secteur équipé d'un modem dLan intégré échange par le biais du réseau électrique avec d'autres modems dLan.
